# DEMANDE DE BREVET EUROPEEN

(11) **EP 4 442 406 A1**
(43) Date de publication de la demande: **09.10.2024**
(21) Numéro de dépôt: 24164244.6
(22) Date de dépôt: 18.03.2024
(51) Int. Cl.: B25J 7/00, B25J 15/00, B25J 15/06, H01L 23/00, H05K 13/04

(54) **PROCÉDÉ ET SYSTÈME DE MANIPULATION D'UN DISPOSITIF MICROMÉTRIQUE**

(30) Priorité: 29.03.2023 FR 2303030
(71) Demandeur: Aledia, 38130 Échirolles (FR)
(72) Inventeur: LEBRUN, Hugues, 38500 COUBLEVIE (FR); MAYER, Frédéric, 38430 Moirans (FR)
(74) Mandataire: Germain Maureau

(57) **Abrégé**

L'invention concerne un système de manipulation (1) destiné à manipuler des dispositifs micrométriques (3), le système de manipulation (1) comprenant un corps principal (10) délimitant intérieurement une chambre d'aspiration (13), des buses d'aspiration (31) comprenant un canal d'aspiration (33) débouchant d'une part vers la chambre d'aspiration (13), et d'autre part au niveau d'une extrémité de préhension (37) destinée à être mise en contact avec un dispositif micrométrique (3) ; des éléments d'obturation (51), configurés pour obturer une buse d'aspiration (31) de sorte à empêcher la préhension d'un dispositif micrométrique (3) ou pour permettre une communication fluidique entre une ouverture de préhension (o37) de l'extrémité de préhension (37) et la chambre d'aspiration (13), de sorte à permettre la préhension d'un dispositif micrométrique (3) en contact avec ladite extrémité de préhension (37).

L'invention concerne également un procédé de manipulation pour manipuler des dispositifs micrométriques (3) par un tel système de manipulation (1).

## Description

### Domaine technique de l'invention

La présente invention concerne un système de manipulation d'au moins un dispositif micrométrique, et notamment d'au moins un dispositif électronique.

L'invention concerne aussi un procédé de manipulation d'un tel dispositif micrométrique.

### Etat de la technique

Dans le domaine des écrans d'affichage lumineux, les éléments lumineux constituants l'écran doivent être agencés de façon matricielle d'une manière de plus en plus précise à mesure que la résolution des écrans augmente. Par ailleurs, pour une taille d'écran donné, cette augmentation de la résolution s'accompagne d'une augmentation du nombre d'éléments lumineux ayant des tailles de plus en plus petites. Ces éléments lumineux comprennent chacun au moins une diode électroluminescente et sont organisés, par exemple, sous la forme d'un pixel multicolore ou sous la forme d'un sous-pixel monochrome.

Il est connu de produire les diodes électroluminescentes sur un support initial sous la forme d'un substrat de silicium ou de saphir et de les reporter, par exemple par compression voire thermocompression, sur un support de réception différent du support initial et destiné à constituer, après ce transfert par pression ou thermocompression, l'écran d'affichage lumineux.

Ainsi, dans le domaine des écrans d'affichage lumineux et plus généralement dans le domaine de la microélectronique ou des nanotechnologies, il existe un besoin de transférer une grande quantité de dispositifs électroniques qui présentent des tailles de plus en plus petites.

Par exemple, dans le cas particulier des diodes électroluminescentes, une étape critique de la fabrication des écrans est de parvenir à transférer une grande quantité de diodes électroluminescentes entre le support initial sur lequel les diodes électroluminescentes sont formées ou fabriquées, et le substrat d'écran final. Par ailleurs, des diodes électroluminescentes peuvent être naturellement endommagées dans le processus général de fabrication. Le transfert de masse implique donc parfois le transfert de diodes électroluminescentes précédemment défectueuses qui sont déposées sur l'écran et constituent des points noirs sur le dispositif final.

Pour tenter de résoudre ce problème, il est possible de procéder à une réparation ou à un changement des diodes électroluminescentes défectueuses. Bien que cette méthode permette de diminuer le nombre de points noirs, elle implique des étapes supplémentaires de fabrication, ce qui peut augmenter les coûts et est fastidieux à implémenter. Une autre solution consiste à créer des zones de redondances, c'est-à-dire des zones dans laquelle une diode fonctionnelle est ajoutée à proximité d'une diode défectueuse. Bien que cette solution donne satisfaction en ce qu'elle limite le nombre de points noirs, elle reste couteuse à mettre en oeuvre.

Une autre méthode dite de « pick and place » selon la dénomination anglo-saxonne dédiée, consiste à déplacer unitairement les diodes électroluminescentes, permettant ainsi de ne sélectionner et transférer que des diodes électroluminescentes dont on est sûr qu'elles sont fonctionnelles. Ceci présente l'avantage d'éviter le recours à une étape de remplacement de diodes transférées défectueuses. Bien que cette deuxième méthode donne satisfaction en ce qu'elle évite la formation de points noirs, elle présente le désavantage d'être très lente à mettre en oeuvre, et génère donc des coûts importants qui sont rédhibitoires dans le cas du transfert en masse de diodes électrolu m inescentes.

Si les problématiques ci-dessus ont été exposées précédemment en lien avec le cas particulier de diodes électroluminescentes, des problématiques similaires ou proches peuvent être présentes dans le cas d'autres dispositifs électroniques qui sont à transférer, comme par exemple les diodes laser à cavité verticale émettant par la surface (ou VECSEL pour vertical-external-cavity surface-emitting-laser selon la terminologie anglo-saxonne consacrée), les photodiodes, les transducteurs ultrasoniques piézoélectriques micro-usinés (ou PMUT pour piezoelectric micromachined ultrasonic transducers selon la terminologie anglo-saxonne consacrée), les transducteurs ultrasonores capacitifs micro-usinés (ou CMUT pour capacitive micromachined ultrasonic transducer selon la terminologie anglo-saxonne consacrée), ou encore les boîtes à lumière.

Les dispositifs à transférer peuvent en outre correspondre à des éléments constitutifs non actifs de dispositifs électroniques, comme par exemple des pastilles de polymère prélevées sur un film pré-découpé à ne déposer que sur certains dispositifs électroniques d'un substrat final. Une telle pastille de film optique spécifique formé sélectivement peut notamment servir de convertisseur de couleur, et à améliorer la luminosité, à filtrer ou compenser localement les longueurs d'onde, etc...

Le dispositif micrométrique, optoélectronique, électronique ou non électronique à manipuler présente typiquement une taille comprise entre 5 micromètres et 500 micromètres.

Il est également connu du document US2020/0258767, une méthode permettant de réaliser le transfert d'une grande quantité de dispositifs électroniques par la solidarisation desdits dispositifs électroniques à des buses. Dans cette méthode, une dépression est appliquée aux buses afin qu'elles puissent aspirer les dispositifs électroniques à transférer. Pour cela, un organe de transfert est pourvu d'une matrice de buses, les buses étant écartées entre elles selon le même écartement que celui séparant les dispositifs électroniques à transférer, et correspondant au pas des pixels sur l'écran. Cependant, bien que cette méthode permette de déplacer simplement un grand nombre de dispositifs électroniques en limitant leur endommagement, il n'est pas possible malheureusement de réaliser un transfert sélectif des dispositifs électroniques, ce qui ne permet pas d'empêcher le transfert de dispositifs électroniques qui seraient défectueux.

### Objet de l'invention

La présente invention a pour but de proposer une solution qui réponde à tout ou partie des problèmes précités.

Ce but peut être atteint grâce à la mise en oeuvre d'un système de manipulation destiné à manipuler une pluralité de dispositifs micrométriques, le système de manipulation comprenant :
- un corps principal délimitant intérieurement une chambre d'aspiration, ladite chambre d'aspiration étant destinée à être en communication fluidique avec un dispositif de dépression ;
- une unité de manipulation comprenant une pluralité de buses d'aspiration, chaque buse d'aspiration de la pluralité de buses d'aspiration comprenant un canal d'aspiration débouchant d'une part vers la chambre d'aspiration au niveau d'une ouverture d'aspiration, et d'autre part au niveau d'une extrémité de préhension destinée à être mise en contact avec un dispositif micrométrique de la pluralité de dispositifs micrométriques ;
- une unité d'obturation comprenant une pluralité d'éléments d'obturation, chaque élément d'obturation étant configuré pour coopérer avec une buse d'aspiration de la pluralité de buses d'aspiration, et étant configuré pour varier entre une configuration de libération dans laquelle l'élément d'obturation obture la buse d'aspiration de sorte à empêcher la préhension d'un dispositif micrométrique en contact avec ladite extrémité de préhension, et une configuration de préhension dans laquelle l'élément d'obturation permet une communication fluidique entre une ouverture de préhension de l'extrémité de préhension et la chambre d'aspiration, de sorte à permettre la préhension d'un dispositif micrométrique en contact avec ladite extrémité de préhension,
l'unité d'obturation comprenant en outre une unité d'actionnement comprenant une pluralité d'actionneurs de déplacement, où chaque actionneur de déplacement est configuré pour faire varier sélectivement au moins l'un des éléments d'obturation entre la configuration de préhension et la configuration de libération.

Les dispositions précédemment décrites permettent de proposer un système de manipulation dans lequel chaque élément d'obturation peut être contrôlé sélectivement afin de permettre ou d'empêcher la solidarisation d'un dispositif micrométrique avec une buse d'aspiration. Il est ainsi possible de prendre sélectivement une pluralité de dispositifs micrométriques par le système de manipulation, par exemple pour effectuer un transfert de masse sélectif de dispositifs micrométriques.

Il est bien compris que lorsqu'un élément d'obturation est dans la configuration de préhension, un dispositif micrométrique en contact avec l'extrémité de préhension de la buse de préhension associée audit élément d'obturation est maintenu en contact avec ladite extrémité de préhension par aspiration. Ladite aspiration étant garantie par l'application d'une dépression à la chambre d'aspiration par le dispositif de dépression, ladite dépression étant alors appliquée également à chaque buse d'aspiration communiquant avec la chambre d'aspiration.

Le système de manipulation peut en outre présenter une ou plusieurs des caractéristiques suivantes, prises seules ou en combinaison.

Selon un mode de réalisation, l'élément d'obturation obture totalement la buse d'aspiration dans la configuration de libération. Alternativement, la configuration de libération peut correspondre à une obturation partielle de la buse d'aspiration par l'élément d'obturation.

Selon un mode de réalisation, chaque actionneur de déplacement est un microsystème électromécanique, ou MEMS pour « microelectromechanical systems » selon la terminologie anglo-saxonne consacrée.

Selon un mode de réalisation, chaque élément d'obturation est un microsystème électromécanique, ou MEMS pour « microelectromechanical systems » selon la terminologie anglo-saxonne consacrée.

Selon un mode de réalisation, le système de manipulation comprend une unité de commande comprenant une pluralité de circuits électroniques de commande, ladite unité de commande étant décalée par rapport à l'unité de manipulation.

Il est donc bien compris que selon ce mode de réalisation, l'unité de commande et l'unité de manipulation sont deux pièces distinctes et indépendantes.

De cette manière, l'unité de commande peut être fabriquée sans nécessiter la présence d'orifices pour la communication fluidique entre les buses d'aspiration et la chambre d'aspiration, ce qui aurait rendu sa conception impossible ou très complexe. Une unité de commande réalisée de façon désolidarisable et décalée de l'unité de manipulation peut alors être conçue comme un élément durable du système de manipulation, à contrario de l'unité de manipulation qui peut être utilisée comme un consommable.

Selon un mode de réalisation, chaque actionneur de déplacement et/ou élément d'obturation est associé à un circuit électronique de commande.

Selon un mode de réalisation, les dispositifs micrométriques à manipuler comprennent des dispositifs électroniques, typiquement des dispositifs optoélectroniques.

Par « dispositif micrométrique », on entend un dispositif comprenant une plus grande dimension inférieure à un millimètre, typiquement comprise entre 5 micromètres et 500 micromètres.

Selon un mode de réalisation, l'actionneur de déplacement et/ou l'élément d'obturation comprend un circuit électronique de commande.

Selon un mode de réalisation, chaque élément d'obturation, et/ou chaque actionneur de déplacement peut être commandé unitairement par le circuit électronique de commande auquel il est associé. Par exemple, ce commandement peut être réalisé en fonction de la répartition matricielle des actionneurs de déplacement et/ou des éléments d'obturation. Chaque actionneur de déplacement et/ou chaque élément d'obturation peut alors être configuré pour recevoir un signal électrique en provenance du circuit électronique de commande auquel il est associé pour provoquer la variation dudit élément d'obturation entre la configuration de préhension et la configuration de libération en fonction dudit signal électrique. Il est ainsi possible d'envoyer un signal électrique par ligne et/ou par colonne pour commander sélectivement et de manière matricielle les éléments d'obturation et/ou les actionneurs de déplacement.

Selon un mode de réalisation, chaque circuit électronique de commande peut comprendre au moins un transistor. Par exemple chaque circuit électronique de commande peut comprendre un transistor de commande configuré pour être commuté de sorte à autoriser ou alternativement empêcher un passage de courant électrique, ledit courant électrique induisant alors un changement de configuration entre la configuration de préhension et la configuration de libération. Le circuit électronique de commande peut également comprendre un transistor de sélection configuré pour recevoir des instructions de ligne et de colonne en provenance d'une unité de commande matricielle, pour faire commuter ou non le transistor de commande en fonction des instructions reçues. Ainsi, le transistor de sélection permet de contrôler l'état de commutation du transistor de commande indépendamment des autres transistors de sélection disposés sur la même ligne ou sur la même colonne.

Selon un mode de réalisation, une aire d'ouverture de l'ouverture de préhension de chaque buse d'aspiration est strictement inférieure à une surface de contact d'un dispositif micrométrique destiné à être manipulé par le système de manipulation.

Selon un mode de réalisation, une plus grande dimension d'une aire d'ouverture de l'ouverture de préhension est strictement inférieure à 1 mm.

De cette manière, lorsque le dispositif micrométrique est en prise avec la buse d'aspiration, il est maintenu par aspiration à la surface de l'unité de manipulation.

Selon un mode de réalisation, au moins un élément d'obturation de la pluralité d'éléments d'obturation comprend au moins un actionneur de déplacement de la pluralité d'actionneurs de déplacement.

En d'autres termes chaque élément d'obturation peut former un actionneur de déplacement et inversement.

Selon un mode de réalisation, les éléments d'obturations sont activés unitairement et/ou sélectivement par les actionneurs de déplacement.

Selon un mode de réalisation, l'élément d'obturation et/ou l'actionneur de déplacement comprend une lame élastiquement déformable, configurée pour varier entre deux configurations spatiales distinctes, l'une étant naturellement occupée par retour élastique de la matière et l'autre étant temporairement occupée sous l'action d'une force externe, typiquement de nature mécanique, électrostatique, thermique, électromagnétique ou tout autre méthode. Alternativement, la configuration recourbée peut être naturellement occupée par retour élastique de la matière, et la configuration plane peut être temporairement occupée sous l'action d'une force externe, typiquement de nature mécanique, électrostatique, thermique, électromagnétique ou tout autre méthode.

Selon un mode de réalisation, au moins un élément d'obturation comprend une membrane flexible.

De manière avantageuse, une membrane présente une épaisseur strictement plus petite qu'un piston. Elle est donc moins encombrante qu'un élément d'obturation rigide, comme peut l'être un piston, elle peut donc plus facilement être intégrée à un système micrométrique. De plus, une membrane peut être réalisée avec une grande variété de matériaux choisis en fonction des besoins d'intégration. Une membrane présente donc une grande facilité d'intégration, par opposition avec un piston qui induit des contraintes sur son intégration.

De cette manière, il est possible de faire varier simplement la membrane flexible entre la configuration de libération et la configuration de préhension. Par exemple, la membrane flexible peut comprendre une portion déformable configurée pour être déformée sous l'action directe ou indirecte de l'actionneur de déplacement.

Selon un mode de réalisation, au moins l'un des éléments d'obturation comprend une portion de coopération présentant une forme tronconique, ladite portion de coopération étant configurée pour coopérer avec l'ouverture d'aspiration de l'une des buses d'aspiration, lorsque ledit au moins un élément d'obturation comprenant la portion de coopération occupe la configuration de libération.

De cette manière, il est possible de déplacer la portion de coopération pour obturer la buse d'aspiration, notamment lorsque l'ouverture d'aspiration présente une section de coupe circulaire.

Selon un mode de réalisation, au moins l'un des actionneurs de déplacement est configuré pour faire varier sélectivement au moins l'un des éléments d'obturation entre la configuration de préhension et la configuration de libération par interaction électrostatique ou magnétique.

Par exemple, ledit au moins un actionneur de déplacement peut comprendre une électrode conductrice, ou un actionneur piézoélectrique.

Selon un mode de réalisation, au moins l'un des actionneurs de déplacement est un système électromécanique micrométrique, ou MEMS pour microelectromechanical system, selon la terminologie anglo-saxonne consacrée.

Par exemple, la mise en oeuvre d'une interaction électrostatique peut consister à imposer une différence de potentiel électrique entre deux électrodes, généralement disposée en vis-à-vis. Le champ électrique créée ainsi une force qui tend à provoquer le rapprochement des électrodes. Par exemple, une des électrodes peut être une électrode flottante, maintenue par un conducteur électrique souple, comme une membrane flexible. Cette électrode flottante peut alors être rapprochée d'une autre électrode voisine, notamment lorsqu'un champ électrique est appliqué entre les 2 électrodes.

Selon un mode de réalisation, la mise en oeuvre d'une interaction magnétique peut consister à provoquer le déplacement de deux objets sous l'application d'un champ magnétique entre ces deux objets, et en exploitant la force de Lorentz ainsi générée pour réaliser ce déplacement.

Selon un mode de réalisation, le système de manipulation comprend un support de guidage comprenant une pluralité de conduits de guidage ménagés dans le support de guidage, chaque conduit de guidage étant configuré pour guider un élément de liaison le long d'une direction de guidage pour provoquer directement ou indirectement une variation d'un des éléments d'obturation entre la configuration de libération et la configuration de préhension.

Selon un mode de réalisation, l'unité de commande est disposée du côté opposé à l'unité de manipulation par rapport au support de guidage.

Selon un mode de réalisation, un élément de liaison est associé à chaque circuit électronique de commande, ledit élément de liaison formant une liaison depuis l'unité de commande jusqu'à l'unité de manipulation entre une buse d'aspiration et le circuit électronique de commande auquel il est associé.

Selon un mode de réalisation, l'élément de liaison comprend une connexion électrique non-mobile, comme une connexion filaire, ledit élément de liaison assurant une connexion électrique entre un circuit électronique de commande et un actionneur de déplacement. Cela est particulièrement avantageux dans le cas où le circuit électronique de commande agit comme un commutateur pour actionner ou non un actionneur de déplacement.

Selon un mode de réalisation, l'élément d'obturation comprend l'élément de liaison, chaque conduit de guidage étant alors disposé en regard de l'une des buses d'aspiration, et configuré pour guider l'élément d'obturation le long de la direction de guidage lorsque ledit élément d'obturation varie entre la configuration de libération et la configuration de préhension.

Selon un mode de réalisation, chaque élément d'obturation s'étend entre une extrémité d'actionnement, et une extrémité d'obturation configurée pour coopérer avec l'ouverture d'aspiration de l'une des buses d'aspiration.

Selon un mode de réalisation, l'élément de liaison s'étend entre une extrémité de contrôle configurée pour coopérer avec un circuit électronique de commande, préférentiellement par l'intermédiaire d'un agent de commutation, et une extrémité de commande configurée pour coopérer avec un actionneur de déplacement.

Selon un mode de réalisation, chaque conduit de guidage peut être décalé par rapport aux buses d'aspiration, chaque conduit de guidage étant configuré pour guider l'un des éléments de liaison le long de la direction de guidage lorsque ledit élément de liaison est actionné de sorte à provoquer une variation d'un des éléments d'obturation entre la configuration de libération et la configuration de préhension.

Il est donc bien compris que les éléments de liaison permettent de déporter les circuits électroniques de commande et éventuellement les actionneurs de déplacement sur un support distinct et distant de l'unité de manipulation comportant les buses d'aspiration. L'unité de commande peut ainsi être un support plein, sans orifice, permettant la réalisation des circuits électroniques de commande, et éventuellement des actionneurs de déplacement, tout en permettant la réalisation d'une chambre d'aspiration en communication fluidique avec chacune des buses d'aspiration de l'unité de manipulation. Il est ainsi possible de remplacer les actionneurs de déplacement, et/ou les circuits électroniques de commande, indépendamment de l'unité de manipulation et des buses d'aspirations. En d'autres termes, l'unité de commande et l'unité de manipulation peuvent être remplacées ou fabriquées indépendamment l'une de l'autre. De manière synergique, le support de guidage permet de faciliter la conception et permet un guidage fiable des éléments de liaison dans les conduits de guidage, notamment s'ils sont mobiles en translation.

Cela est particulièrement avantageux lors de la fabrication du système de manipulation, car il est possible de fabriquer séparément l'unité de manipulation qui comprend les buses d'aspiration destinées à être en contact des dispositifs micrométriques, et l'unité de commande qui comprend les circuits électroniques de commande et éventuellement les actionneurs de déplacement. En effet, la fabrication de l'unité de manipulation est rendue complexe par le nombre et la forme des buses de manipulation qui constituent des pièces d'usure du système de manipulation. A l'inverse, l'unité de commande comprend les circuits électroniques de commande dont le coût de fabrication peut être plus élevé, mais dont l'usure est plus lente car ils n'entrent pas en contact avec d'autres pièces.

De cette manière, il est possible de prévoir un système de manipulation dans lequel la répartition des conduits de guidage correspond à la répartition des buses d'aspiration.

Selon un mode de réalisation, chaque conduit de guidage est configuré pour guider en translation les éléments d'obturation le long de la direction de guidage.

Selon un mode de réalisation, le support de guidage est disposé dans la chambre d'aspiration, par exemple entre les actionneurs de déplacement et les buses d'aspiration.

Selon un mode de réalisation, le support de guidage forme au moins partiellement une paroi de la chambre d'aspiration.

Selon un mode de réalisation, chaque élément d'obturation comprend une tige d'obturation mobile en translation dans un conduit de guidage de la pluralité de conduits de guidage, ladite tige d'obturation s'étendant entre une extrémité d'actionnement une extrémité d'obturation configurée pour coopérer avec l'ouverture d'aspiration de l'une des buses d'aspiration.

Selon un mode de réalisation, l'extrémité d'actionnement de la tige d'obturation est configurée pour coopérer avec l'un des actionneurs de déplacement.

De cette manière, l'actionnement des éléments d'obturation est effectué à une extrémité opposée de celle où est effectuée l'obturation des buses d'aspiration, il est donc possible de réparer ou remplacer indépendamment l'unité de manipulation et l'unité d'obturation.

Selon un mode de réalisation l'élément d'obturation est fixé à l'actionneur de déplacement. Par exemple, l'élément d'obturation peut être dans la configuration de libération dans une position de repos dans laquelle aucun actionnement n'est mis en oeuvre par l'actionneur de déplacement, et peut varier dans la configuration de préhension lorsque l'actionneur de déplacement est actionné.

Alternativement, l'élément d'obturation peut être dans la configuration de préhension dans une position de repos dans laquelle aucun actionnement n'est mis en oeuvre par l'actionneur de déplacement, et peut varier dans la configuration de libération lorsque l'actionneur de déplacement est actionné.

Selon un mode de réalisation :
- les buses d'aspiration de l'unité de manipulation sont disposées selon une première répartition matricielle définie par au moins un premier paramètre de maille,
- les éléments d'obturation de l'unité d'obturation sont disposés selon une deuxième répartition matricielle définie par au moins un deuxième paramètre de maille;
l'un du premier paramètre de maille et du deuxième paramètre de maille étant un multiple entier de l'autre.

Selon un mode de réalisation, les actionneurs de déplacement de l'unité d'actionnement sont disposés selon une troisième répartition matricielle définie par au moins un troisième paramètre de maille, le premier paramètre de maille, le deuxième paramètre de maille, et le troisième paramètre de maille étant des multiples entiers les uns des autres.

Selon un mode de réalisation, les actionneurs de déplacement sont disposés selon une troisième répartition matricielle définie par au moins un troisième paramètre de maille qui est un multiple entier du deuxième paramètre de maille, le système de manipulation comprenant en outre une unité de commande comprenant une pluralité de circuits électroniques de commande répartis selon une quatrième répartition matricielle définie par au moins un quatrième paramètre de maille qui est un multiple entier du troisième paramètre de maille, chaque actionneur de déplacement étant associé à un circuit électronique de commande et configuré pour recevoir un signal électrique en provenance du circuit électronique de commande auquel il est associé pour provoquer la variation dudit élément d'obturation entre la configuration de préhension et la configuration de libération en fonction dudit signal électrique.

Selon un mode de réalisation, le premier paramètre de maille est égal au deuxième paramètre de maille, et/ou au troisième paramètre de maille.

Ainsi, le système de manipulation peut avantageusement être utilisé pour manipuler des dispositifs micrométriques disposés selon une répartition matricielle sur un substrat de prélèvement.

Le but de l'invention peut également être atteint grâce à la mise en oeuvre d'un procédé de manipulation d'une pluralité de dispositifs micrométriques où chaque dispositif micrométrique présente une surface de contact, le procédé de manipulation comprenant :
- une phase de fourniture dans laquelle un système de manipulation du type d'un de ceux décrits précédemment est fourni, l'extrémité de préhension d'au moins l'une des buses d'aspiration étant en contact avec la surface de contact d'au moins l'un desdits dispositifs micrométriques;
- une phase d'actionnement dans laquelle au moins l'un des éléments d'obturation coopérant avec l'une des buses d'aspiration en contact avec l'un des dispositifs micrométriques est varié entre la configuration de préhension et la configuration de libération, la phase d'actionnement comprenant alors, pour au moins l'un des éléments d'obturation variant de configuration, choisi parmi ledit au moins l'un des éléments d'obturation :
   ∘ une étape de solidarisation dans laquelle le dispositif micrométrique est solidarisé avec la buse d'aspiration lorsque ledit élément d'obturation variant de configuration est varié vers la configuration de préhension, ou
   ∘ une étape de séparation dans laquelle le dispositif micrométrique est séparé de la buse d'aspiration lorsque ledit élément d'obturation variant de configuration est varié vers la configuration de libération.

Il est donc bien compris que l'étape de solidarisation peut être mise en oeuvre lorsqu'un élément d'obturation est varié vers, ou est dans la configuration de préhension. Il est également bien compris que l'étape de séparation peut être mise en oeuvre lorsqu'un élément d'obturation est varié vers, ou est dans la configuration de libération.

Les dispositions précédemment décrites permettent de proposer un procédé de manipulation dans lequel des dispositifs micrométriques peuvent être attachés ou détachés du système de manipulation par un actionnement sélectif des actionneurs de déplacement. Cela permet de manipuler sélectivement une grande quantité de dispositifs micrométriques, par une seule étape de procédé, et par l'intermédiaire d'un seul système de manipulation.

Le procédé de manipulation peut en outre présenter une ou plusieurs des caractéristiques suivantes, prises seules ou en combinaison.

Selon un mode de réalisation, la phase de fourniture comprend :
- une étape de mise à disposition du système de manipulation du type d'un de ceux décrits précédemment;
- une étape de mise à disposition de la pluralité de dispositifs micrométriques disposés sur un substrat de prélèvement ;
- une étape de mise en contact, dans laquelle l'extrémité de préhension d'au moins l'une des buses d'aspiration est mise en contact avec la surface de contact d'au moins l'un des dispositifs micrométriques.

Ainsi, la phase de fourniture peut être mise en oeuvre afin de prendre un ou plusieurs dispositifs micrométriques à la surface d'un substrat de prélèvement, par exemple afin de les transférer.

Selon un mode de réalisation, le procédé de manipulation comprend une étape de décrochage mise en oeuvre après la phase d'actionnement, dans laquelle le système de manipulation est écarté du substrat de prélèvement, de manière à décrocher, par rapport au substrat de prélèvement, les dispositifs micrométriques solidarisés avec des buses d'aspiration lors de l'étape de solidarisation.

De cette manière il est possible de collecter sélectivement les dispositifs micrométriques à manipuler depuis la surface du substrat de prélèvement.

Selon un mode de réalisation, l'étape de décrochage est mise en oeuvre par traction mécanique.

Selon un mode de réalisation, la phase d'actionnement est mise en oeuvre lorsqu'au moins l'un des actionneurs de déplacement de l'unité d'actionnement est actionné, de sorte à provoquer la variation d'au moins l'un des éléments d'obturation coopérant avec l'une des buses d'aspiration en contact avec l'un des dispositifs micrométriques entre la configuration de préhension et la configuration de libération.

Selon un mode de réalisation, la phase d'actionnement est mise en oeuvre par un actionnement magnétique ou électrostatique de l'au moins l'un des actionneurs de déplacement.

Selon un mode de réalisation, la phase d'actionnement est mise en oeuvre par un actionnement thermique ou mécanique de l'au moins un actionneur de déplacement.

Selon un mode de réalisation, le procédé de manipulation comprend une étape de transfert mise en oeuvre après la phase de fourniture, dans laquelle le système de manipulation est placé en regard d'un support de réception apte à recevoir au moins l'un des dispositifs micrométriques manipulés.

De cette manière il est possible de mettre en place les dispositifs micrométriques en regard d'une surface de réception du support de réception pouvant être le support de destination final des dispositifs micrométriques. Dans le cas où les dispositifs micrométriques sont des dispositifs optoélectroniques, l'étape de transfert peut être mise en oeuvre de sorte à placer les dispositifs optoélectronique en regard d'un substrat d'écran.

Selon un mode de réalisation, le procédé de manipulation comprend une étape d'alignement dans laquelle le système de manipulation est aligné avec le support de réception. De cette manière, il est possible de déterminer précisément l'emplacement au niveau duquel chaque dispositif micrométrique peut être déposé sur le support de réception. Par exemple, dans le cas d'une manipulation de dispositifs électronique, l'étape d'alignement peut être mise en oeuvre de manière à aligner chaque dispositif électronique avec des éléments électriquement conducteurs disposés sur le support de réception et configurés pour alimenter les dispositifs électroniques en énergie électrique.

Selon un mode de réalisation, le procédé de manipulation comprend une étape de dépôt, mise en oeuvre après l'étape de transfert, dans laquelle le système de manipulation est approché du support de réception, de manière à mettre en contact directement ou indirectement, des dispositifs micrométriques manipulés, avec ledit support de réception final. Par exemple, dans le cas d'une manipulation de dispositifs électronique, chaque dispositif électronique est mis en contact avec les éléments électriquement conducteurs.

Selon un mode de réalisation, le procédé de manipulation comprend une étape de retrait, mise en oeuvre après l'étape de dépôt, dans laquelle le système de manipulation est éloigné du support de réception.

Selon un mode de réalisation, l'un au moins des dispositifs micrométriques à manipuler est un dispositif électronique, le procédé de manipulation comprenant une étape de test dans laquelle ledit au moins un dispositif électronique est testé électriquement afin de déterminer s'il est fonctionnel ou non fonctionnel, la phase d'actionnement étant alors mise en oeuvre en fonction du résultat de l'étape de test.

De cette manière, en fonction de la destination des dispositifs électroniques il est possible d'adapter la phase d'actionnement.

Selon un mode de réalisation, la phase d'actionnement est appliquée sélectivement de manière à mettre en oeuvre l'étape de solidarisation pour les dispositifs électroniques fonctionnels, et de manière à mettre en oeuvre l'étape de séparation pour les dispositifs électronique non fonctionnels.

De cette manière, il est possible de prendre et éventuellement déplacer les dispositifs fonctionnels, par exemple pour les transférer vers un support de réception final.

Selon un autre mode de réalisation, la phase d'actionnement est appliquée sélectivement de manière à mettre en oeuvre l'étape de séparation pour les dispositifs électroniques fonctionnels, et de manière à mettre en oeuvre l'étape de solidarisation pour les dispositifs électronique non fonctionnels.

De cette manière, il est possible de prendre et éventuellement déplacer les dispositifs non fonctionnels, par exemple pour les retirer d'un substrat de réception final, ou d'un substrat de prélèvement avant d'effectuer un transfert de masse non sélectifs des dispositifs fonctionnels restants à la surface du substrat de prélèvement.

### Description sommaire des dessins

D'autres aspects, buts, avantages et caractéristiques de l'invention apparaîtront mieux à la lecture de la description détaillée suivante de modes de réalisation préférés de celle-ci, donnée à titre d'exemple non limitatif, et faite en référence aux dessins annexés sur lesquels :
La figure 1 est une vue schématique d'un système de manipulation selon un premier mode de réalisation de l'invention.
La figure 2 est une vue schématique d'un système de manipulation selon un deuxième mode de réalisation de l'invention.
La figure 3 est une vue schématique de certains éléments d'un système de manipulation selon un troisième mode de réalisation de l'invention.
La figure 4 est une vue schématique de certaines étapes du procédé de manipulation selon un mode de réalisation particulier de l'invention.
La figure 5 est une vue schématique de certaines étapes du procédé de manipulation selon un mode de réalisation particulier de l'invention.
La figure 6 est une vue schématique de certaines étapes du procédé de manipulation selon un mode de réalisation particulier de l'invention.

### Description détaillée

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux.

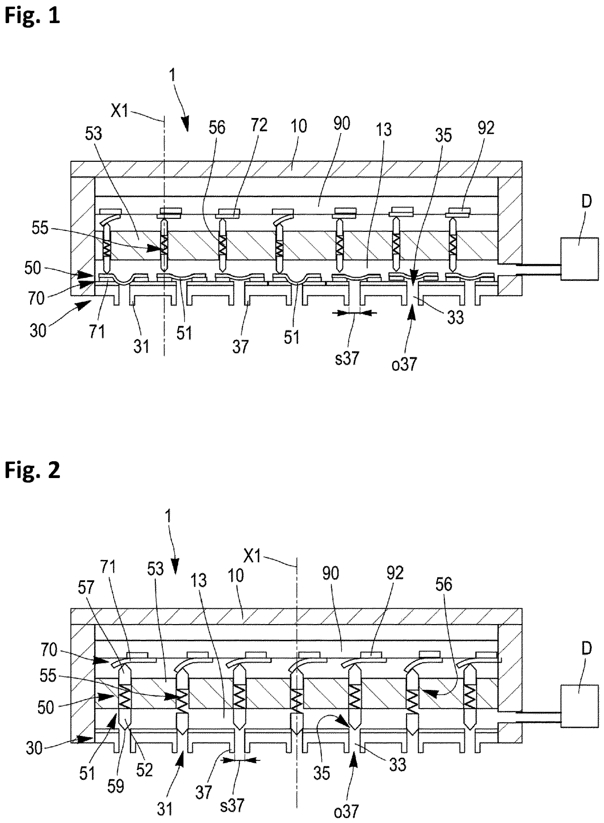

Comme cela est illustré sur les figures 1 et 2, l'invention concerne un système de manipulation 1 destiné à manipuler des dispositifs micrométriques 3. Comme cela sera décrit plus loin en référence au procédé de manipulation, les dispositifs micrométriques 3 peuvent être disposés, avant manipulation, sur un support de prélèvement 2, et comprennent une surface de contact s3. De manière générale, par « dispositif micrométrique », on entend un dispositif comprenant une plus grande dimension inférieure à un millimètre, et typiquement comprise entre 5 micromètres et 500 micromètres. Sans que cela ne soit limitatif, il peut être prévu que chaque dispositif micrométrique 3 soit un dispositif électronique, ou un dispositif optoélectronique. Ainsi, le système de manipulation est adapté pour le transfert de masse de dispositifs optoélectroniques, par exemple dans un procédé de fabrication d'écrans d'affichage.

Le système de manipulation 1 comprend un corps principal 10 délimitant intérieurement une chambre d'aspiration 13, ladite chambre d'aspiration 13 étant destinée à être en communication fluidique avec un dispositif de dépression noté « D », externe au système de manipulation 1. Ce système de dépression D est configuré pour placer la chambre d'aspiration 13 en dépression par rapport à la pression régnant à l'extérieur du système de manipulation 1.

Les figures 1 et 2 illustrent deux modes de réalisation distincts de l'invention, mais qui peuvent tout deux être utilisés pour mettre en oeuvre le procédé de manipulation qui sera décrit ci-après. Le système de manipulation 1 de ces deux figures comprend une unité de manipulation 30 comprenant une pluralité de buses d'aspiration 31; une unité d'obturation 50 comprenant une pluralité d'éléments d'obturation 51, et qui comprend une unité d'actionnement 70 comprenant une pluralité d'actionneurs de déplacement 71. Le système de manipulation 1 peut également comprendre une unité de commande 90 comprenant une pluralité de circuits électroniques de commande 92, qui peut être décalée par rapport à l'unité de manipulation 30. Il est donc bien compris que l'unité de commande 90 et l'unité de manipulation 30 peuvent être deux pièces distinctes et indépendantes. Sur les variantes non limitatives des figures 1 et 2, l'unité de manipulation 30 comprend sept buses d'aspiration 31, l'unité d'obturation 50 comprend sept éléments d'obturation 51, l'unité d'actionnement 70 comprend sept actionneurs de déplacement 71, et l'unité de commande 92 comprend sept circuits électroniques de commande. Il est d'ailleurs possible que toutes les buses d'aspiration 31 soient identiques, que tous les éléments d'obturation 51 soient identiques, que tous les actionneurs de déplacement 71 soient identiques, et/ou que tous les circuits électroniques de commande 92 soient identiques. Ainsi, pour améliorer la lecture des figures, l'ensemble des références numériques n'ont pas été répétées pour les sept composants 31, 51, 71, 92. Par ailleurs, dans la suite de la description, le positionnement de chaque composant 31, 51, 71, 92 est compté de la gauche vers la droite.

De manière avantageuse, et sans que cela ne soit limitatif, les buses d'aspiration 31 de l'unité de manipulation 30 peuvent être disposées selon une première répartition matricielle définie par au moins un premier paramètre de maille, les éléments d'obturation 51 de l'unité d'obturation 50 peuvent être disposés selon une deuxième répartition matricielle définie par au moins un deuxième paramètre de maille, les actionneurs de déplacement 71 de l'unité d'actionnement 70 peuvent être disposés selon une troisième répartition matricielle définie par au moins un troisième paramètre de maille, et les circuits électroniques de commande 92 sont répartis selon une quatrième répartition matricielle définie par au moins un quatrième paramètre de maille. Le premier paramètre de maille, le deuxième paramètre de maille, le troisième paramètre de maille, et le quatrième paramètre de maille peuvent être des multiples entiers les uns des autres. Cependant, il est avantageux que le premier paramètre de maille soit égal au deuxième paramètre de maille, au troisième paramètre de maille, et/ou au quatrième paramètre de maille. Ainsi, le système de manipulation 1 peut être utilisé pour manipuler des dispositifs micrométriques 3 disposés selon une répartition matricielle sur un support de prélèvement 2, par exemple suivant une répartition matricielle correspondant à l'un des premier, deuxième troisième, et quatrième paramètres de maille.

Chaque buse d'aspiration 31 de la pluralité de buses d'aspiration 31 comprend un canal d'aspiration 33 débouchant d'une part vers la chambre d'aspiration 13 au niveau d'une ouverture d'aspiration 35, et d'autre part au niveau d'une extrémité de préhension 37 destinée à être mise en contact avec un dispositif micrométrique 3 de la pluralité de dispositifs micrométriques 3. Ainsi, lorsque la chambre d'aspiration 13 est placée en dépression par le dispositif de dépression D, les buses d'aspirations 31 sont aptes à aspirer tout élément à proximité ou en contact avec une ouverture de préhension o37 de l'extrémité de préhension 37. De manière avantageuse, il peut être prévu qu'une aire d'ouverture s37 de l'ouverture de préhension 37 de chaque buse d'aspiration 31 soit strictement inférieure à une surface de contact s3 d'un dispositif micrométrique 3. De cette manière, lorsque le dispositif micrométrique 3 est en prise avec la buse d'aspiration 31, il est maintenu par aspiration au niveau de l'unité de manipulation 30. Généralement, une plus grande dimension de l'aire d'ouverture s 37 de l'ouverture de préhension 37 est strictement inférieure à 1 mm.

Chaque élément d'obturation 51 est configuré pour coopérer avec une buse d'aspiration 31 de la pluralité de buses d'aspiration 31, et pour varier entre une configuration de libération dans laquelle l'élément d'obturation 51 obture la buse d'aspiration 31 de sorte à empêcher la préhension d'un dispositif micrométrique 3 en contact avec ladite extrémité de préhension 37, et une configuration de préhension dans laquelle l'élément d'obturation 51 permet une communication fluidique entre l'ouverture de préhension o37 et la chambre d'aspiration 13, de sorte à permettre la préhension d'un dispositif micrométrique 3 en contact avec ladite extrémité de préhension 37. Il est bien compris que lorsqu'un élément d'obturation 51 est dans la configuration de préhension, un dispositif micrométrique 3 en contact avec l'extrémité de préhension 37 de la buse de préhension associée audit élément d'obturation 51 est maintenu en contact avec ladite extrémité de préhension 37 par aspiration au niveau de l'ouverture de préhension o37. Ladite aspiration étant garantie par l'application d'une dépression à la chambre d'aspiration 13 par le dispositif de dépression D, ladite dépression étant alors appliquée également à chaque buse d'aspiration 31 communiquant avec la chambre d'aspiration 13. L'élément d'obturation 51 peut soit obturer totalement la buse d'aspiration 31 dans la configuration de libération, soit obturer partiellement la buse d'aspiration 31, dans la configuration de libération.

Enfin, chaque actionneur de déplacement 71 est configuré pour faire varier sélectivement au moins l'un des éléments d'obturation 51 entre la configuration de préhension et la configuration de libération. Plus précisément chaque élément d'obturation 51 peut être activé unitairement et/ou sélectivement par un actionneur de déplacement 71. De manière générale, chaque actionneur de déplacement 71 est un microsystème électromécanique, ou MEMS pour « microelectromechanical systems » selon la terminologie anglo-saxonne consacrée. Chaque actionneur de déplacement 71 peut être associé à un circuit électronique de commande 92, ou peut comprendre un circuit électronique de commande 92. De manière avantageuse, les actionneurs de déplacement 71 peuvent être configurés pour faire varier sélectivement au moins l'un des éléments d'obturation 51 entre la configuration de préhension et la configuration de libération par interaction électrostatique ou magnétique. Par exemple, ledit au moins un actionneur de déplacement 71 peut comprendre une électrode conductrice, ou un actionneur piézoélectrique.

Par exemple, la mise en oeuvre d'une interaction électrostatique peut consister à imposer une différence de potentiel électrique entre deux électrodes, généralement disposée en vis-à-vis. Le champ électrique créée ainsi une force qui tend à provoquer le rapprochement des électrodes. Par exemple, une des électrodes peut être une électrode flottante, maintenue par un conducteur électrique souple. Cette électrode flottante peut alors être rapprochée d'une autre électrode voisine, notamment lorsqu'un champ électrique est appliqué entre les 2 électrodes.

Alternativement, la mise en oeuvre d'une interaction magnétique peut consister à provoquer le déplacement de deux objets sous l'application d'un champ magnétique entre ces deux objets, et en exploitant la force de Lorentz ainsi générée pour réaliser ce déplacement.

De manière générale, chaque élément d'obturation 51, et/ou chaque actionneur de déplacement 71 est commandé unitairement par le circuit électronique de commande 92 auquel il est associé. Par exemple, ce commandement peut être réalisé en fonction de la répartition matricielle des buses d'aspiration 31.

Comme cela est illustré sur les figures, un élément de liaison 56 peut être associé à chaque circuit électronique de commande 92. Cet élément de liaison 56 forme une liaison depuis l'unité de commande 90 jusqu'à l'unité de manipulation 30 entre une buse d'aspiration 31 et le circuit électronique de commande 92 auquel il est associé. En fonction des variantes considérées, les éléments de liaison 56 peuvent être
- des éléments de liaison 56 mobiles comme cela est illustré sur les figures 1 et 2 ; ou
- des éléments de liaison fixes (non représentés).

Dans le deuxième cas, les éléments de liaisons peuvent correspondre à des fils conducteurs configurés pour assurer une liaison électrique entre l'unité de commande 90 et l'unité de manipulation 30. Plus précisément, les éléments de liaison permettent ainsi une connexion électrique entre un circuit électronique de commande 92 et un actionneur de déplacement 71. Cela est particulièrement avantageux dans le cas où le circuit électronique de commande 92 agit comme un commutateur pour actionner ou non l'actionneur de déplacement 71.

La présence des éléments de liaison 56 permet le déport ou l'écartement de l'unité de commande 90 par rapport à l'unité de manipulation 30 et facilite la conception de l'unité de commande 90 qui peut ainsi être réalisé à partir d'un support plein.

Comme cela est illustré sur les figures 1 et 2, le système de manipulation peut comprendre un support de guidage 53, disposé entre l'unité de manipulation 30 et l'unité de commande 90, comprenant une pluralité de conduits de guidage 55 ménagés dans le support de guidage 53.

Chaque conduit de guidage 55 peut être configuré pour guider un élément de liaison 56 le long d'une direction de guidage notée « X1 » pour provoquer directement ou indirectement une variation d'un des éléments d'obturation 51 entre la configuration de libération et la configuration de préhension. De manière synergique, le support de guidage 53 permet de faciliter la conception du système de manipulation et permet un guidage fiable des éléments de liaison 56 dans les conduits de guidage 55, notamment s'ils sont mobiles en translation.

Sur la variante représentée sur la figure 1, les éléments d'obturation 51 comprennent une membrane flexible comprenant une portion déformable configurée pour être déformée sous l'action indirecte de l'actionneur de déplacement 71. De manière avantageuse, une membrane présente une épaisseur strictement plus petite qu'un piston. Elle est donc moins encombrante qu'un élément d'obturation 51 rigide, comme peut l'être un piston, elle peut donc plus facilement être intégrée à un système micrométrique. De plus, une membrane peut être réalisée avec une grande variété de matériaux choisis en fonction des besoins d'intégration. Une membrane présente donc une grande facilité d'intégration, par opposition avec un piston qui induit des contraintes sur son intégration. Chaque élément de liaison 56 peut être guidé en translation dans un conduit de guidage 55 le long de la direction de guidage X1. Chaque élément de liaison 56 peut alors coopérer d'une part avec un agent de commutation 72 pouvant appartenir à l'unité de commande 90, et d'autre part avec l'actionneur de déplacement 71. Dans le cas particulier de la figure 1, les actionneurs de déplacement 71 sont des électrodes conductrices pouvant toutes avoir un potentiel commun. Dans ce cas, l'élément de liaison 56 peut être une tige conductrice configurée pour transmettre un signal électrique à l'actionneur de déplacement 71 soit lorsque l'élément de liaison 56 est déplacé, soit, si l'élément de liaison est fixe, lorsque l'agent de commutation 72 entre en contact avec l'élément de liaison 56. Dans le cas où l'élément de liaison 56 est mobile, lorsque l'agent de commutation 72 est déplacé, il déplace dans le même temps le déplacement de l'élément de liaison 56 qui provoque alors la déformation de la membrane flexible de l'élément d'obturation 51. Dans le cas où l'élément de liaison 56 est fixe, c'est l'agent de commutation 72 qui est configuré pour venir en contact ou non avec l'élément de liaison 56 pour provoquer la déformation de la membrane flexible de l'élément d'obturation 51. Alternativement, l'agent de commutation est un simple interrupteur électronique incorporé dans le circuit électronique de commande 92 et transmet un signal électrique à l'actionneur de déplacement 71 par l'intermédiaire d'un élément de liaison fixe, par exemple un fil électrique, connecté d'un côté au circuit électronique de commande 92 et de l'autre côté à l'actionneur de déplacement 71. Ces différentes variantes permettent de faire varier simplement la membrane flexible de l'élément d'obturation 51 entre la configuration de libération et la configuration de préhension.

Selon la variante représentée sur la figure 2, au moins l'un des éléments d'obturation 51 comprend une portion de coopération 52 présentant une forme tronconique, ladite portion de coopération 52 étant configurée pour coopérer avec l'ouverture d'aspiration 35 de l'une des buses d'aspiration 31, lorsque ledit au moins un élément d'obturation 51 comprenant la portion de coopération 52 occupe la configuration de libération. De cette manière, il est possible de déplacer la portion de coopération 52 pour obturer la buse d'aspiration 31, notamment lorsque l'ouverture d'aspiration 35 présente une section de coupe circulaire. En particulier, chaque élément d'obturation 51 peut comprendre une tige d'obturation mobile en translation dans un conduit de guidage 55 de la pluralité de conduits de guidage 55, ladite tige d'obturation s'étendant entre une extrémité d'actionnement 57, typiquement configurée pour coopérer avec l'un des actionneurs de déplacement 71, et une extrémité d'obturation 59 configurée pour coopérer avec l'ouverture d'aspiration 35 de l'une des buses d'aspiration 31. Sans que cela ne soit limitatif, ladite tige d'obturation peut être séparée en une première partie de tige comprenant l'extrémité d'actionnement 57, et une deuxième partie de tige comprendre l'extrémité d'obturation 59, la première partie de tige et la deuxième partie de tige étant reliée par un dispositif de rappel comme un ressort. De cette manière, l'actionnement des éléments d'obturation 51 est effectué à une extrémité opposée de celle où est effectuée l'obturation des buses d'aspiration 31, il est donc possible de réparer ou remplacer indépendamment l'unité de manipulation 30 et l'unité d'obturation 50. Il est possible que l'élément d'obturation 51 soit fixé à l'actionneur de déplacement 71. Par exemple, l'élément d'obturation 51 peut être dans la configuration de libération dans une position de repos dans laquelle aucun actionnement n'est mis en oeuvre par l'actionneur de déplacement 71, et peut varier dans la configuration de préhension lorsque l'actionneur de déplacement 71 est actionné. Alternativement, l'élément d'obturation 51 peut être dans la configuration de préhension dans une position de repos dans laquelle aucun actionnement n'est mis en oeuvre par l'actionneur de déplacement 71, et peut varier dans la configuration de libération lorsque l'actionneur de déplacement 71 est actionné. Enfin, selon un mode de réalisation, au moins un élément d'obturation 51 de la pluralité d'éléments d'obturation 51 comprend au moins un actionneur de déplacement 71 de la pluralité d'actionneurs de déplacement 71. En d'autres termes chaque élément d'obturation 51 peut former un actionneur de déplacement 71 et inversement.

Dans le cas où l'unité d'obturation 50 comprend un support de guidage 53, chaque conduit de guidage 55 peut être disposé en regard de l'une des buses d'aspiration 31, et chaque élément de liaison 56-peut comprendre un élément d'obturation 51. Ainsi, chaque conduit de guidage 55 peut être configuré pour guider, par exemple par translation, l'éléments d'obturation 51 le long de la direction de guidage X1 lorsque ledit élément d'obturation 51 varie entre la configuration de libération et la configuration de préhension. De cette manière, il est possible de prévoir un système de manipulation 1 dans lequel la répartition des conduits de guidage 55 correspond à la répartition des buses d'aspiration 31.

Chaque circuit électronique de commande 92 peut comprendre un ou plusieurs transistors. Par exemple chaque circuit électronique de commande 92 peut comprendre un transistor de commande configuré pour être commuté de sorte à autoriser ou alternativement empêcher un passage de courant électrique, ledit courant électrique induisant alors un changement de configuration entre la configuration de préhension et la configuration de libération. Le circuit électronique de commande 92 peut également comprendre un transistor de sélection configuré pour recevoir des instructions de ligne et de colonne en provenance d'un système de commande matriciel, pour faire commuter ou non le transistor de commande en fonction des instructions reçues. Ainsi, le transistor de sélection permet de contrôler l'état de commutation du transistor de commande indépendamment des autres transistors de sélection disposés sur la même ligne ou sur la même colonne.

Sur la variante représentée sur la figure 1, c'est l'agent de commutation 72 qui peut être configuré pour recevoir un signal électrique en provenance du circuit électronique de commande 92 auquel il est associé pour déplacer l'élément de liaison 56 et ainsi provoquer la variation de l'élément d'obturation 51 correspondant entre la configuration de préhension et la configuration de libération en fonction dudit signal électrique. Il est ainsi possible d'envoyer des signaux électriques par ligne et par colonne pour commander sélectivement et de manière matricielle les éléments d'obturation 51 par l'intermédiaire de l'élément de liaison 56, et de l'agent de commutation 72.

Sur la variante représentée sur la figure 2, chaque actionneur de déplacement 71 peut être configuré pour recevoir un signal électrique en provenance du circuit électronique de commande 92 auquel il est associé pour provoquer la variation de l'élément d'obturation 51 correspondant entre la configuration de préhension et la configuration de libération en fonction dudit signal électrique. Il est ainsi possible d'envoyer des signaux électriques par ligne et par colonne pour commander sélectivement et de manière matricielle les actionneurs de déplacement 71.

Quel que soit la variante considérée, il est bien compris que l'élément de liaison 46 permet de déporter les actionneurs de déplacement 71 et/ou les circuits électroniques de commande 92, du côté opposé à celui des buses d'aspiration 31. Il est ainsi possible de remplacer les actionneurs de déplacement 71, et/ou les circuits électroniques de commande 92, indépendamment des buses de manipulation 31. En d'autres termes, l'unité de commande 90 et l'unité de manipulation 30 peuvent être remplacées ou fabriquées indépendamment l'une de l'autre. Cela est particulièrement avantageux lors de la fabrication du système de manipulation 1, car il est possible de fabriquer séparément l'unité de manipulation 30 qui comprend les buses de manipulation 31 destinées à être en contact des dispositifs micrométriques 3, et l'unité de commande 90 qui comprend les circuits électroniques de commande 92. En effet, la fabrication de l'unité de manipulation 30 est rendue complexe par le nombre et la forme des buses de manipulation 31 qui constituent des pièces d'usure du système de manipulation 1. A l'inverse, l'unité de commande 90 comprend les circuits électroniques de commande 92 dont le coût de fabrication peut être plus élevé, mais dont l'usure est plus lente car ils n'entrent pas en contact avec d'autres pièces. L'unité de manipulation 90 est un substrat plein comportant les circuits électroniques de commande 92 et le système de commande matriciel avec le quadrillage de pistes électriques associées permettant notamment l'envoi aux circuit électroniques de commande 92 d'instructions de ligne et de colonne et bornes d'alimentation électriques.

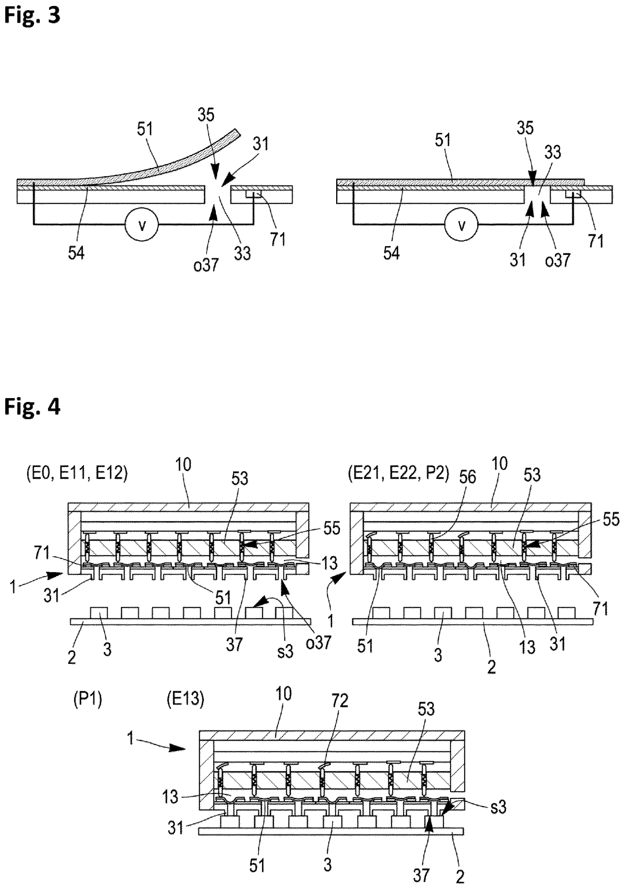

La figure 3 illustre une autre variante dans laquelle l'élément d'obturation 51 et/ou l'actionneur de déplacement 71 comprend une lame élastiquement déformable, configurée pour varier entre deux configurations spatiales distinctes, l'une (par exemple une configuration plane) étant naturellement occupée par retour élastique de la matière et l'autre (par exemple une configuration recourbée) étant temporairement occupée sous l'action d'une force externe, typiquement de nature mécanique, électrostatique, thermique, électromagnétique ou tout autre méthode. Alternativement, la configuration recourbée peut être naturellement occupée par retour élastique de la matière, et la configuration plane peut être temporairement occupée sous l'action d'une force externe, typiquement de nature mécanique, électrostatique, thermique, électromagnétique ou tout autre méthode. Pour cela, l'actionneur de déplacement 71 peut être disposé sous une couche diélectrique 54, et peut attirer ou repousser la lame élastiquement déformable formant l'élément d'obturation 51 pour respectivement fermer, ou ouvrir le canal d'aspiration 33 de la buse d'aspiration 31. Il est bien compris qu'une telle variante peut être simplement adaptée aux systèmes de manipulation 1 des figures 1 et 2 en lieu et place des buses d'aspirations 31, des éléments d'obturation 51, et/ou des actionneurs de déplacement 71.

Les dispositions précédemment décrites permettent de proposer un système de manipulation 1 dans lequel chaque élément d'obturation 51 peut être contrôlé sélectivement par un actionneur de déplacement 71 afin de permettre ou d'empêcher la solidarisation d'un dispositif micrométrique 3 avec une buse d'aspiration 31. Il est ainsi possible de prendre sélectivement une pluralité de dispositifs micrométriques 3 par le système de manipulation 1, par exemple pour effectuer un transfert de masse sélectif de dispositifs micrométriques 3.

Comme cela est illustré sur les figures 4 à 6, l'invention concerne également un procédé de manipulation pour manipuler des dispositifs micrométriques 3 où chaque dispositif micrométrique 3 présente une surface de contact s3. Le mode de réalisation du procédé de manipulation présenté sur les figures 4 à 6 présente les étapes du procédé dans un certain ordre, mais il est bien compris que l'homme du métier peut ordonner les différentes étapes du procédé comme il le souhaite pour manipuler les dispositifs micrométriques 3.

Selon une variante non limitative dans laquelle un ou plusieurs des dispositifs micrométrique 3 est un dispositif électronique, le procédé de manipulation peut comprendre une étape de test E0 dans laquelle chaque dispositif électronique est testé électriquement afin de déterminer s'il est fonctionnel ou non fonctionnel. Une telle étape de test E0 peut être mise en oeuvre au début du procédé de manipulation, ou à d'autres moments du procédé de manipulation.

Le procédé de manipulation comprend en outre une phase de fourniture P1 dans laquelle un système de manipulation 1 du type d'un de ceux décrits précédemment est fourni. Il est bien compris que même si le mode de réalisation du procédé de manipulation décrit sur les figures 4 à 6 est en référence à un système de manipulation 1 tel que décrit sur la figure 1, il est tout à fait possible de l'adapter à un système de manipulation tel que décrit à la figure 2 ou comprenant les éléments décrits à la figure 3. Par exemple un tel système de manipulation peut être fourni lors d'une étape de mise à disposition E11 du système de manipulation 1.

La phase de fourniture P1 peut également comprendre une étape de mise à disposition E12 de la pluralité de dispositifs micrométriques 3 disposés sur le substrat de prélèvement 2. Il peut ensuite être prévu de mettre en oeuvre une étape de mise en contact E13, dans laquelle l'extrémité de préhension 37 d'au moins l'une des buses d'aspiration 31 est mise en contact avec la surface de contact s3 d'au moins l'un des dispositifs micrométriques 3. Il en résulte qu'à la fin de la phase de fourniture P1, l'extrémité de préhension 37 d'au moins l'une des buses d'aspiration 31 est en contact avec la surface de contact s3 d'au moins l'un desdits dispositifs micrométriques 3. Ainsi, la phase de fourniture P1 peut être mise en oeuvre afin de prendre un ou plusieurs dispositifs micrométriques 3 à la surface d'un substrat de prélèvement 2, par exemple afin de les transférer.

Le procédé de manipulation comprend également une phase d'actionnement P2 dans laquelle au moins l'un des actionneurs de déplacement 71 de l'unité d'actionnement 70 du système de manipulation 1 est actionné, de sorte à provoquer la variation d'au moins l'un des éléments d'obturation 51 coopérant avec l'une des buses d'aspiration 31 en contact avec l'un des dispositifs micrométriques 3 entre la configuration de préhension et la configuration de libération, la phase d'actionnement P2 comprenant alors, pour au moins l'un des éléments d'obturation 51 variant de configuration, choisi parmi ledit au moins l'un des éléments d'obturation 51 :
- une étape de solidarisation E21 dans laquelle le dispositif micrométrique 3 est solidarisé avec la buse d'aspiration 31 lorsque ledit élément d'obturation 51 variant de configuration est varié vers la configuration de préhension, ou
- une étape de séparation E22 dans laquelle le dispositif micrométrique 3 est séparé de la buse d'aspiration 31 lorsque ledit élément d'obturation 51 variant de configuration est varié vers la configuration de libération.

Il est donc bien compris que l'étape de solidarisation E21 peut être mise en oeuvre lorsqu'un élément d'obturation 51 est varié vers, ou est dans la configuration de préhension. Il est également bien compris que l'étape de séparation E22 peut être mise en oeuvre lorsqu'un élément d'obturation 51 est varié vers, ou est dans la configuration de libération.

Comme cela est représenté sur la figure 4, la phase d'actionnement P2 peut également comprendre la variation d'au moins l'un des éléments d'obturation 51 coopérant avec l'une des buses d'aspiration 31 depuis la configuration de préhension vers la configuration de libération, ou depuis la configuration de libération vers la configuration de préhension avant la mise en contact de l'extrémité de préhension 37 avec la surface de contact s3 du dispositif micrométrique. Cette phase d'actionnement P2 peut être mise en oeuvre par un actionnement magnétique ou électrostatique de l'au moins l'un des actionneurs de déplacement 71, par un actionnement thermique ou mécanique de l'au moins un actionneur de déplacement 71, ou tout autre moyen. De cette manière, en fonction de la destination des dispositifs micrométriques 3 il est possible d'adapter la phase d'actionnement P2.

Quel que soit la variante considérée, la phase d'actionnement P2 peut être mise en oeuvre en fonction du résultat de l'étape de test E0. Par exemple, la phase d'actionnement P2 peut être appliquée sélectivement de manière à mettre en oeuvre l'étape de solidarisation E21 pour les dispositifs électroniques 3 fonctionnels, et de manière à mettre en oeuvre l'étape de séparation E22 pour les dispositifs électroniques non fonctionnels. De cette manière, il est possible de prendre et éventuellement déplacer les dispositifs fonctionnels, par exemple pour les transférer vers un support de réception 4 final. Alternativement, la phase d'actionnement P2 peut être appliquée sélectivement de manière à mettre en oeuvre l'étape de séparation E22 pour les dispositifs électroniques 3 fonctionnels, et de manière à mettre en oeuvre l'étape de solidarisation E21 pour les dispositifs électroniques non fonctionnels. De cette manière, il est possible de prendre et éventuellement déplacer les dispositifs non fonctionnels, par exemple pour les retirer d'un substrat de réception final, ou d'un substrat de prélèvement 2 avant d'effectuer un transfert de masse non sélectifs des dispositifs fonctionnels restants à la surface du substrat de prélèvement 2. Sur l'exemple représenté sur la figure 4, l'étape de test E0 peut avoir révélé que les dispositifs électroniques 3 disposés en première et quatrième position étaient défectueux. Par conséquent, la phase d'actionnement P2 est mise en oeuvre pour faire varier les éléments d'obturation 51 en première et quatrième position dans la configuration de libération.

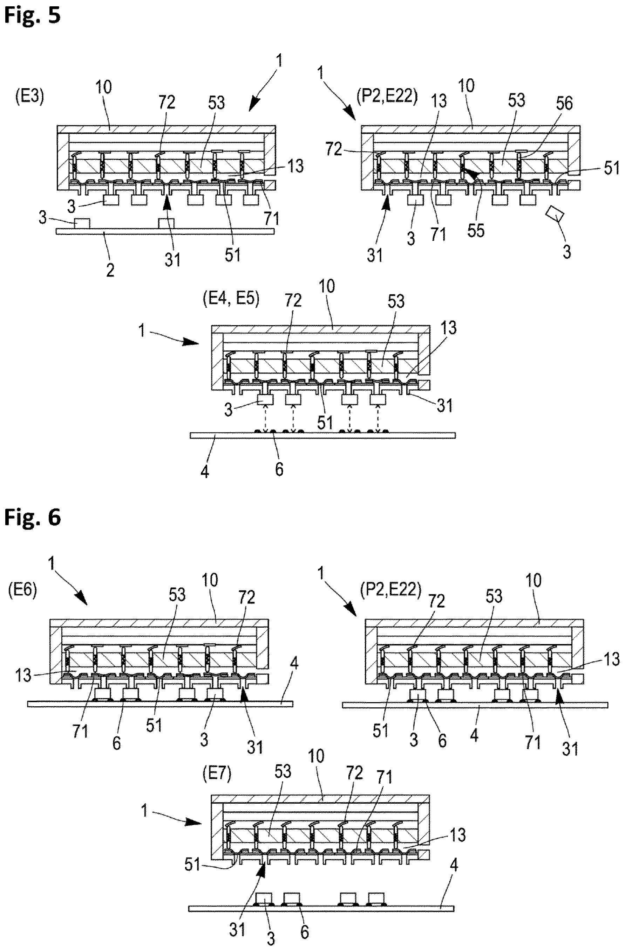

En référence à la figure 5, le procédé de manipulation comprend une étape de décrochage E3 mise en oeuvre après la phase d'actionnement P2, dans laquelle le système de manipulation 1 est écarté du substrat de prélèvement 2, de manière à décrocher, par rapport au substrat de prélèvement 2, les dispositifs micrométriques 3 solidarisés avec des buses d'aspiration 31 lors de l'étape de solidarisation E21. Par exemple, l'étape de décrochage E3 est mise en oeuvre par traction mécanique. De cette manière il est possible de collecter sélectivement les dispositifs micrométriques 3 à manipuler depuis la surface du substrat de prélèvement 2. Sur le mode de réalisation de la figure 5, seuls les dispositifs micrométriques 3 disposés entre première et quatrième position ne sont pas solidarisés avec le système de manipulation 1, car les éléments d'obturations 51 placés en première et quatrième position sont dans la configuration de libération. Par conséquent, l'aspiration au niveau des buses d'aspirations 31 situées en première et quatrième position n'est pas suffisante pour permettre de détachement des dispositifs micrométriques 3 en contact avec ces buses d'aspirations 31, ils restent donc à la surface du support de prélèvement 2.

Comme cela est illustré sur la figure 5, il est possible de mettre en oeuvre à nouveau la phase d'actionnement P2. En particulier, la figure 5 montre qu'une étape de séparation E22 est mise en oeuvre au niveau de la buse d'aspiration 31 située en septième position. Lors de cette étape de séparation E22, l'élément d'obturation 51 varie de la configuration de préhension vers la configuration de libération. Le dispositif micrométrique 3 correspondant est alors séparé de la buse d'aspiration 31, et le dispositif micrométrique 3 en septième position est alors détaché du système de manipulation 1. Cette étape de séparation E22 peut par exemple avoir été mise en oeuvre suite à une deuxième étape de test E0 ayant révélé la non-fonctionnalité du dispositif électronique 3 disposé en septième position.

Ainsi, de manière générale, la phase d'actionnement P2 est mise en oeuvre pour les dispositifs électroniques 3 non fonctionnels, ou pour libérer des dispositifs électroniques 3 fonctionnels que l'on ne souhaite pas transférer. De cette manière, il est possible de prendre et éventuellement déplacer les dispositifs électroniques 3 fonctionnels, par exemple pour les transférer vers un support de réception final 4

Pour cela, le procédé de manipulation peut comprendre une étape de transfert E4 mise en oeuvre après la phase de fourniture P1, dans laquelle le système de manipulation 1 est placé en regard d'un support de réception 4 apte à recevoir au moins l'un des dispositifs micrométriques 3 manipulés. De cette manière il est possible de mettre en place les dispositifs micrométriques 3 en regard d'une surface de réception du support de réception 4 pouvant être le support de destination final des dispositifs micrométriques 3. Dans le cas où les dispositifs micrométriques 3 sont des dispositifs électroniques ou optoélectroniques, l'étape de transfert E4 peut être mise en oeuvre de sorte à placer les dispositifs optoélectroniques en regard d'un substrat d'écran.

De manière avantageuse, le procédé de manipulation peut comprendre une étape d'alignement E5 dans laquelle le système de manipulation 1 est aligné avec le support de réception 4. De cette manière, il est possible de déterminer précisément l'emplacement au niveau duquel chaque dispositif micrométrique 3 peut être déposé sur le support de réception 4. Par exemple, si les dispositifs micrométrique 3 sont des dispositifs électroniques ou optoélectroniques, l'étape d'alignement E5 peut être mise en oeuvre de manière à aligner chaque dispositif électronique 3 avec des éléments électriquement conducteurs 6 disposés sur le support de réception 4 et configurés pour alimenter les dispositifs électroniques 3 en énergie électrique.

Ensuite, le procédé de manipulation peut comprendre une étape de dépôt E6, mise en oeuvre après l'étape de transfert E4, dans laquelle le système de manipulation 1 est approché du support de réception 4, de manière à mettre en contact directement ou indirectement, des dispositifs micrométriques 3 manipulés, avec ledit support de réception 4 final. Par exemple, chaque dispositif électronique 3 est mis en contact avec les éléments électriquement conducteurs 6.

Comme cela est illustré à la figure 3, une autre phase d'actionnement P2 peut être mise en oeuvre. En particulier, une étape de séparation E22 peut être réalisée pour actionner l'ensemble des actionneurs de déplacement 71 du système de manipulation 1, de sorte à provoquer le passage de tous les éléments d'obturation 51 de la configuration de préhension à la configuration de libération, pour provoquer le détachement des dispositifs micrométriques 3 restants.

Enfin, le procédé de manipulation peut comprendre une étape de retrait E7, mise en oeuvre après l'étape de dépôt E6, dans laquelle le système de manipulation 1 est éloigné du support de réception 4.

Les dispositions précédemment décrites permettent de proposer un procédé de manipulation dans lequel des dispositifs micrométriques 3 peuvent être attachés ou détachés du système de manipulation 1 par un actionnement sélectif des actionneurs de déplacement 71. Cela permet de manipuler sélectivement une grande quantité de dispositifs micrométriques 3, par une seule étape de procédé, et par l'intermédiaire d'un seul système de manipulation 1.

## Revendications

1. Système de manipulation (1) destiné à manipuler une pluralité de dispositifs micrométriques (3), le système de manipulation (1) comprenant :
- un corps principal (10) délimitant intérieurement une chambre d'aspiration (13), ladite chambre d'aspiration (13) étant destinée à être en communication fluidique avec un dispositif de dépression (D);
- une unité de manipulation (30) comprenant une pluralité de buses d'aspiration (31), chaque buse d'aspiration (31) de la pluralité de buses d'aspiration (31) comprenant un canal d'aspiration (33) débouchant d'une part vers la chambre d'aspiration (13) au niveau d'une ouverture d'aspiration (35), et d'autre part au niveau d'une extrémité de préhension (37) destinée à être mise en contact avec un dispositif micrométrique (3) de la pluralité de dispositifs micrométriques (3) ;
- une unité d'obturation (50) comprenant une pluralité d'éléments d'obturation (51), chaque élément d'obturation (51) étant configuré pour coopérer avec une buse d'aspiration (31) de la pluralité de buses d'aspiration (31), et étant configuré pour varier entre une configuration de libération dans laquelle l'élément d'obturation (51) obture la buse d'aspiration (31) de sorte à empêcher la préhension d'un dispositif micrométrique (3) en contact avec ladite extrémité de préhension (37), et une configuration de préhension dans laquelle l'élément d'obturation (51) permet une communication fluidique entre une ouverture de préhension (o37) de l'extrémité de préhension (37) et la chambre d'aspiration (13), de sorte à permettre la préhension d'un dispositif micrométrique (3) en contact avec ladite extrémité de préhension (37), l'unité d'obturation (50) comprenant en outre une unité d'actionnement (70) comprenant une pluralité d'actionneurs de déplacement (71), où chaque actionneur de déplacement (71) est configuré pour faire varier sélectivement au moins l'un des éléments d'obturation (51) entre la configuration de préhension et la configuration de libération.

2. Système de manipulation (1) selon la revendication 1, dans lequel une aire d'ouverture (s37) de l'ouverture de préhension (o37) de chaque buse d'aspiration (31) est strictement inférieure à une surface de contact (s3) d'un dispositif micrométrique (3) destiné à être manipulé par le système de manipulation (1).

3. Système de manipulation (1) selon l'une quelconque des revendications 1 ou 2, dans lequel au moins un élément d'obturation (51) comprend une membrane flexible.

4. Système de manipulation (1) selon l'une quelconque des revendications 1 à 3, dans lequel au moins l'un des éléments d'obturation (51) comprend une portion de coopération (52) présentant une forme tronconique, ladite portion de coopération (52) étant configurée pour coopérer avec l'ouverture d'aspiration (35) de l'une des buses d'aspiration (31), lorsque ledit au moins un élément d'obturation (51) comprenant la portion de coopération (52) occupe la configuration de libération.

5. Système de manipulation (1) selon l'une quelconque des revendications 1 à 4, dans lequel au moins l'un des actionneurs de déplacement (71) est configuré pour faire varier sélectivement au moins l'un des éléments d'obturation (51) entre la configuration de préhension et la configuration de libération par interaction électrostatique ou magnétique.

6. Système de manipulation (1) selon l'une quelconque des revendications 1 à 5, comprenant un support de guidage (53) comprenant une pluralité de conduits de guidage (55) ménagés dans le support de guidage (53), chaque conduit de guidage (55) étant configuré pour guider un élément de liaison (56) le long d'une direction de guidage (X1), pour provoquer directement ou indirectement une variation d'un des éléments d'obturation (51) entre la configuration de libération et la configuration de préhension.

7. Système de manipulation (1) selon l'une quelconque des revendications 1 à 6, dans lequel :
- les buses d'aspiration (31) de l'unité de manipulation (30) sont disposées selon une première répartition matricielle définie par au moins un premier paramètre de maille,
- les éléments d'obturation (51) de l'unité d'obturation (50) sont disposés selon une deuxième répartition matricielle définie par au moins un deuxième paramètre de maille ;
l'un du premier paramètre de maille et du deuxième paramètre de maille étant un multiple entier de l'autre.

8. Système de manipulation (1) selon l'une quelconque des revendications 1 à 7, comprenant une unité de commande (90) comprenant une pluralité de circuits électroniques de commande (92), ladite unité de commande (90) étant décalée par rapport à l'unité de manipulation (30).

9. Système de manipulation (1) selon la revendication 8, dans lequel un élément de liaison (56) est associé à chaque circuit électronique de commande (92), ledit élément de liaison (56) formant une liaison depuis l'unité de commande (90) jusqu'à l'unité de manipulation (30) entre une buse d'aspiration (31) et le circuit électronique de commande (92) auquel il est associé.

10. Procédé de manipulation d'une pluralité de dispositifs micrométriques (3) où chaque dispositif micrométrique (3) présente une surface de contact (s3), le procédé de manipulation comprenant :
- une phase de fourniture (P1) dans laquelle un système de manipulation (1) selon l'une quelconque des revendications 1 à 9 est fourni, l'extrémité de préhension (37) d'au moins l'une des buses d'aspiration (31) étant en contact avec la surface de contact (s3) d'au moins l'un desdits dispositifs micrométriques (3);
- une phase d'actionnement (P2) dans laquelle au moins l'un des éléments d'obturation (51) coopérant avec l'une des buses d'aspiration (31) en contact avec l'un des dispositifs micrométriques (3) est varié entre la configuration de préhension et la configuration de libération, la phase d'actionnement (P2) comprenant alors, pour au moins l'un des éléments d'obturation (51) variant de configuration, choisi parmi ledit au moins l'un des éléments d'obturation (51) :
• une étape de solidarisation (E21) dans laquelle le dispositif micrométrique (3) est solidarisé avec la buse d'aspiration (31) lorsque ledit élément d'obturation (51) variant de configuration est varié vers la configuration de préhension, ou
• une étape de séparation (E22) dans laquelle le dispositif micrométrique (3) est séparé de la buse d'aspiration (31) lorsque ledit élément d'obturation (51) variant de configuration est varié vers la configuration de libération.

11. Procédé de manipulation selon la revendication 10, dans lequel la phase de fourniture (P1) comprend :
- une étape de mise à disposition (E11) du système de manipulation (1) selon l'une quelconque des revendications 1 à 9;
- une étape de mise à disposition (E12) de la pluralité de dispositifs micrométriques (3) disposés sur un substrat de prélèvement (2) ;
- une étape de mise en contact (E13), dans laquelle l'extrémité de préhension (37) d'au moins l'une des buses d'aspiration (31) est mise en contact avec la surface de contact (s3) d'au moins l'un des dispositifs micrométriques (3).

12. Procédé de manipulation selon l'une quelconque des revendications 10 ou 11, dans lequel la phase d'actionnement (P2) est mise en oeuvre lorsqu'au moins l'un des actionneurs de déplacement (71) de l'unité d'actionnement (70) est actionné, de sorte à provoquer la variation d'au moins l'un des éléments d'obturation (51) coopérant avec l'une des buses d'aspiration (31) en contact avec l'un des dispositifs micrométriques (3) entre la configuration de préhension et la configuration de libération.

13. Procédé de manipulation selon la revendication 12, dans lequel la phase d'actionnement (P2) est mise en oeuvre par un actionnement magnétique ou électrostatique de l'au moins l'un des actionneurs de déplacement (71).

14. Procédé de manipulation selon l'une quelconque des revendications 10 à 13, comprenant une étape de transfert (E4) mise en oeuvre après la phase de fourniture (P1), dans laquelle le système de manipulation (1) est placé en regard d'un support de réception (4) apte à recevoir au moins l'un des dispositifs micrométriques (3) manipulés.

15. Procédé de manipulation selon l'une quelconque des revendications 10 à 14, dans lequel l'un au moins des dispositifs micrométriques (3) à manipuler est un dispositif électronique, le procédé de manipulation comprenant une étape de test (E0) dans laquelle ledit au moins un dispositif électronique est testé électriquement afin de déterminer s'il est fonctionnel ou non fonctionnel, la phase d'actionnement (P2) étant alors mise en oeuvre en fonction du résultat de l'étape de test (E0).
